# EUROPÄISCHE PATENTSCHRIFT

(11) **EP 3 446 382 B1**
(45) Veröffentlichungstag und Bekanntmachung des Hinweises auf die Patenterteilung: **03.11.2021**
(21) Anmeldenummer: 17718015.5
(22) Anmeldetag: 24.03.2017
(51) Int. Cl.: H02B 1/56, H05K 7/20

(54) **SCHALTSCHRANKANORDNUNG MIT EINEM IN EINEM SCHALTSCHRANKGEHÄUSE AUFGENOMMENEN KÜHLGERÄT**
ELECTRICAL ENCLOSURE ARRANGEMENT COMPRISING AN ELECTRICAL ENCLOSURE HOUSING AND A COOLING DEVICE IN IT
ENSEMBLE D'ARMOIRES ÉLECTRIQUES AVEC UNE CAISEE D'ARMOIRES ÉLECTRIQUES ET UN APPAREIL DE REFROIDISSEMENT INTÉGRÉ DEDANS

(30) Priorität: 22.04.2016 DE 102016107531
(43) Veröffentlichungstag der Anmeldung: 27.02.2019
(73) Patentinhaber: Rittal GmbH & Co. KG, 35745 Herborn (DE)
(72) Erfinder: CACHO ALONSO, Juan Carlos, 38102 Braunschweig (DE); IMMEL, Manfred, 35756 Mittenaar 1 (DE); SCHWIETZ, Sandra, 35708 Haiger (DE); MESCHKAT, Jan, 35625 Hüttenberg (DE)
(74) Vertreter: Angerhausen, Christoph
(86) Internationale Anmeldenummer: PCT/DE2017/100242
(87) Internationale Veröffentlichungsnummer: WO 2017/182025

(56) Entgegenhaltungen:
- DE-A1- 19 917 641
- DE-C1- 10 205 653
- US-A- 5 467 250
- US-A- 6 164 369
- US-A1- 2011 063 778

## Beschreibung

Die Erfindung, die im Anspruch 1 offenbart ist, geht aus von einer Schaltschrankanordnung mit einem in einem Schaltschrankgehäuse aufgenommenen Kühlgerät, wobei das Kühlgerät über eine Linearverstelleinheit, insbesondere ein Schienensystem, an dem Schaltschrankgehäuse verschieblich gehalten und zwischen einer Auszugposition und einer Einschubposition verstellt werden kann, wobei das Kühlgerät in der Einschubposition vollständig in dem Schaltschrankgehäuse aufgenommen und in der Auszugposition zumindest anteilig über eine Türseite des Schaltschrankgehäuses aus dem Schaltschrankgehäuse herausragt.

Eine derartige Schaltschrankanordnung ist aus der DE 20 2008 003 516 U1 bekannt.

Hierbei weist das Kühlgerät ein Peltier-Element auf und ist über an gegenüberliegenden Seitenwänden des Schaltschrankgehäuses vorgesehene Schienen in das Schaltschrankgehäuse einschiebbar. Für die Rückkühlung der Warmseite des Peltier-Elements ist an der Rückwand des Schaltschrankgehäuses eine Luftdurchlassöffnung ausgebildet, welche in eine Warmluftauslassöffnung des Peltier-Kühlgeräts mündet. Weitere Schaltschrankanordnungen sind aus der DE 199 17 641 A1, US6164369A, US5467250A, der US 2011/063778 A1 und der DE 102 05 653 C1 bekannt.

Die aus dem Stand der Technik bekannten Kühlgeräte haben aufgrund ihrer Verwendung von Peltier-Elementen als aktives Kühlmittel den Nachteil, dass sie nur vergleichsweise geringe Kühlleistungen bereitstellen und damit für viele IT-Anwendungen sowie Anwendungen im Leistungselektronikbereich häufig nicht den Kühlleistungsbedarf decken können.

Es ist daher die Aufgabe der Erfindung, die bekannte Schaltschrankanordnung derart weiter zu entwickeln, dass sie auch in Verbindung mit Kühlgeräten höherer Leistungsklassen, insbesondere in Verbindung mit Kältemaschinen, Anwendung finden kann.

Diese Aufgabe wird von einer Schaltschrankanordnung mit den Merkmalen des Anspruchs 1 gelöst. Die abhängigen Ansprüche betreffen jeweils vorteilhafte Ausführungsformen der Erfindung.

Demgemäß weist ein die Türseite des Schaltschrankgehäuses in seiner Schließstellung verschließendes Türelement mindestens eine Luftdurchlassöffnung auf, die bei sich in der Einschubposition befindendem Kühlgerät in der Schließstellung des Türelements in einen Luftauslass und einen Lufteinlass des Kühlgeräts mündet. Das Türelement weist separate Luftdurchlassöffnungen auf, von denen eine erste in den Luftauslass und eine zweite in den Lufteinlass mündet.

Dadurch, dass bei der erfindungsgemäßen Schaltschrankanordnung die Luftdurchlassöffnung an einem frontseitigen Türelement des Schaltschrankgehäuses vorgesehen ist, ist sichergestellt, dass über die Luftdurchlassöffnung ein für die Rückkühlung beispielsweise eines Verflüssigers einer Kältemaschine ausreichendes Luftvolumen bereitgestellt werden kann. Insbesondere dann, wenn gattungsgemäße Schaltschrankanordnungen mit ihrer Rückseite angrenzend an eine Gebäudewand aufgestellt sind, kann mit den aus dem Stand der Technik bekannten Anordnungen nicht die Luftvolumenzufuhr, welche für Kühlgeräte höherer Leistungsklassen jedoch erforderlich ist, gewährleistet sein.

Das Kühlgerät weist ein Kühlgerätgehäuse mit einer Lufteinlassseite und einer Luftauslassseite auf, die in der Schließstellung des Türelements dem Türelement zugewandt und vorzugsweise parallel zu diesem angeordnet sind.

Das Türelement kann an seiner dem Kühlgerät in der Schließstellung zugewandten Türinnenseite ein die Luftdurchlassöffnung umlaufendes Dichtelement, insbesondere einen Dichtrahmen aufweisen. Anstelle des Dichtrahmens kann auch eine geschäumte oder extrudierte Dichtung vorgesehen sein. Das Dichtelement kann dabei so bemessen sein, dass es in der Schließstellung des Türelements die Türinnenseite gegenüber der Umrandung des Luftauslasses und/oder des Lufteinlasses des Kühlgeräts abdichtet.

In der Schließstellung soll sowohl der Luftauslass als auch der Lufteinlass des Kühlgeräts in die Luftdurchlassöffnung münden, wobei die Luftdurchlassöffnung zweiteilig ausgebildet ist, mit einer Lufteintrittsöffnung, die in den Lufteinlass des Kühlgeräts mündet, und einer von der Lufteintrittsöffnung fluidisch abgetrennten Luftaustrittsöffnung, die in den Luftauslass des Kühlgeräts mündet.

Dabei können die Lufteintrittsöffnung und die Luftaustrittsöffnung über einen die Luftdurchlassöffnung unterteilenden Trennsteg fluidisch voneinander getrennt sein, wobei der Trennsteg an der dem Kühlgerät in der Schließstellung des Türelements zugewandten Türinnenseite eine vorstehende Schottung, insbesondere eine Bürstenleiste aufweist, so dass ein Luftkurzschluss zwischen Lufteinlass und Luftauslass unterbunden wird.

Weiterhin kann zumindest die Luftaustrittsöffnung eine Luftleitgeometrie, insbesondere Lamellen, aufweisen, die dazu eingerichtet ist, über die Luftaustrittsöffnung aus dem Schaltschrankgehäuse austretende Luft in eine von der Lufteintrittsöffnung abgewandte Richtung zu leiten.

Die Luftdurchlassöffnung kann eine Lufteintrittsöffnung aufweisen, die in Luftströmungsrichtung durch die Lufteintrittsöffnung nachgelagert an einer dem Kühlgerät in der Schließstellung des Türelements zugewandten Türinnenseite einen Luftfilter, insbesondere eine Filtermatte, aufweist. Auf diese Weise kann vermieden werden, dass der Außenkreis des Kühlgeräts mit Verunreinigungen aus der Umgebung der Schaltschrankanordnung kontaminiert wird.

Das Kühlgerät kann ein Horizontaleinschubgerät sein, welches in einer Einschubebene parallel zu einer Dachseite und/oder einer Bodenseite des Schaltschrankgehäuses verstellbar ist. Das Kühlgerät kann alternativ ein Vertikaleinschubgerät sein, welches in einer Einschubebene parallel zu einer Seitenwand des Schaltschranks verstellbar ist.

In dem Fall, dass das Kühlgerät ein Horizontaleinschubgerät ist, kann sich das Kühlgerät an seiner dem Türelement zugewandten Vorderseite über das gesamte lichte horizontale Maß des Schaltschrankinnenraums erstrecken. Wenn das Kühlgerät ein Vertikaleinschubgerät ist, kann sich das Kühlgerät an seiner dem Türelement zugewandten Vorderseite über das gesamte lichte vertikale Einbaumaß des Schaltschrankinnenraums erstrecken.

In beiden Fällen kann vorgesehen sein, dass das Kühlgerät an seiner einer Rückwand des Schaltschrankgehäuses zugewandten Rückseite einen Sammelschienentransferraum aufweist, der als ein horizontaler Durchlass durch das Kühlgerät ausgebildet ist. Diese Ausführungsform ist insbesondere dann vorteilhaft, wenn die Schaltschrankanordnung Bestandteil einer Schaltschrankreihe ist, bei der eine Vielzahl gattungsgemäßer Schaltschrankanordnungen und/oder Schaltschrankgehäuse eine Schaltschrankreihe bilden, welche über ein Sammelschienensystem, das sich durch die aneinander grenzenden Seiten der einzelnen Schaltschrankgehäuse hindurch zwischen den Schaltschrankgehäusen erstreckt, mit elektrischer Energie versorgt wird.

Wenn das Kühlgerät ein Vertikaleinschubgerät ist, kann es angrenzend an zwei seitliche Vertikalprofile eines Rahmengestells des Schaltschrankgehäuses angeordnet sein, so dass ein Schaltschrankinnenraum für die Aufnahme von elektronischen Komponenten von einer von diesen Vertikalprofilen abgewandten Seitenwand des Kühlgeräts begrenzt ist.

Dabei kann das Schaltschrankgehäuse an der Türseite eine doppelflügelige Türanordnung aufweisen, mit einem ersten Türelement, das die Luftdurchlassöffnung aufweist, und mit einem zweiten Türelement, das den Schaltschrankinnenraum wahlweise verschließt, so dass das Kühlgerät bei geöffnetem ersten Türelement und bei geschlossenem zweiten Türelement zwischen der Einschubposition und der Auszugposition verstellt werden kann. Auf diese Weise ist gewährleistet, dass beispielsweise im Wartungsfall des Kühlgeräts der unter Umständen mit sensiblen Einbauten bestückte Schaltschrankinnenraum nicht geöffnet werden muss und so beispielsweise gegenüber unbefugtem Zugriff geschützt ist.

Dabei kann weiterhin vorgesehen sein, dass sich das Vertikaleinschubgerät in seiner Tiefenrichtung parallel zur Einschubrichtung in der Einschubposition im Wesentlichen über die gesamte Tiefe des Schaltschrankinnenraums erstreckt oder zumindest eine Vorderseite des Gehäuses des Vertikaleinschubgeräts mit der Türseite des Schaltschrankgehäuses fluchtet.

An einer Außenseite des Türelements kann ein Gerätedisplay des Kühlgeräts angeordnet sein, wobei ein Anschlusskabel des Gerätedisplays durch das Türelement hindurch geführt ist und an einer dem Kühlgerät in der Schließstellung des Türelements zugewandten Türinnenseite aus dem Türelement heraustritt, wobei das Kühlgerät an seiner dem Türelement zugewandten Vorderseite eine Kabelbox zur Aufnahme des Anschlusskabels aufweist.

Die Kabelbox kann einen Kabeleintritt aufweisen, über den das an der Türinnenseite des Türelements austretende Anschlusskabel in das Kühlgerät eintritt, wobei das Anschlusskabel in Richtung des Kabeleintritts vorgespannt ist. Vorzugsweise ist der Kabeleintritt an einer der Türinnenseite des Türelements zugewandten Vorderseite des Kühlgeräts angeordnet. Die Kabelbox kann an einer dem Kabeleintritt abgewandten und im Inneren des Kühlgeräts liegenden Rückseite einen Kabelaustritt aufweisen, über den das Gerätekabel aus der Kabelbox heraustritt und zu einem Steuergerät des Kühlgeräts geführt ist.

Das Türelement kann entweder eine an dem Schaltschrankgehäuse über Scharniere schwenkbar befestigte Schaltschranktür oder eine an einer vertikalen, in der Einschubposition der Türseite des Schaltschrankgehäuses zugewandten Gehäuseseite des Kühlgeräts montierte Türpaneele sein, wobei die Paneele senkrecht zu der Türseite, d.h. linear, verstellbar ist.

In dem Fall, dass das Türelement eine linear verstellbare Türpaneele ist, kann diese fest mit der Gehäuseseite des Kühlgeräts verbunden sein und an ihrer von dem Kühlgerät abgewandten Außenseite einen Griff aufweisen, sodass das Kühlgerät mit der Türpaneele zwischen der Einschubposition und der Auszugposition verstellbar ist.

Weitere Einzelheiten der Erfindung werden anhand der nachstehenden Figuren erläutert. Dabei zeigt:
- Figur 1: den oberen Teil einer Schaltschrankanordnung nach einer ersten Ausführungsform der Erfindung, wobei sich das Kühlgerät in einer Auszugposition befindet;
- Figur 2: die Ausführungsform nach Figur 1, wobei sich das Kühlgerät in der Einschubposition befindet;
- Figur 3: die Ausführungsform nach den Figuren 1 und 2, wobei sich das Kühlgerät in der Schließstellung befindet;
- Figur 4: die Ausführungsform nach Figur 3, wobei zur besseren Veranschaulichung das Kühlgerät und eine Seitenwand entfernt sind;
- Figur 5: eine Schaltschrankanordnung nach einer weiteren Ausführungsform der Erfindung;
- Figur 6: die Ausführungsform nach Figur 5 mit geöffneten Türelementen,
- Figur 7: eine Detailansicht der Darstellung gemäß Figur 6;
- Figur 8: eine Ausführungsform einer Kabelbox gemäß Figur 7,
- Figur 9: eine Detailansicht der Darstellung gemäß Figur 6;
- Figur 10: die Ausführungsform nach Figur 6 mit entnommenem Kühlgerät;
- Figur 11: eine Detailansicht der Darstellung gemäß Figur 10; und
- Figur 12: eine Ausführungsform, bei der das Türelement eine Türpaneele ist.

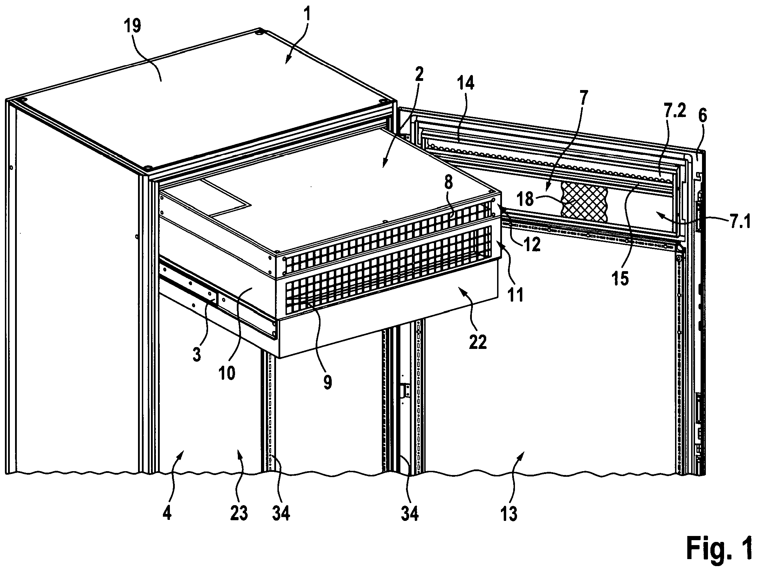

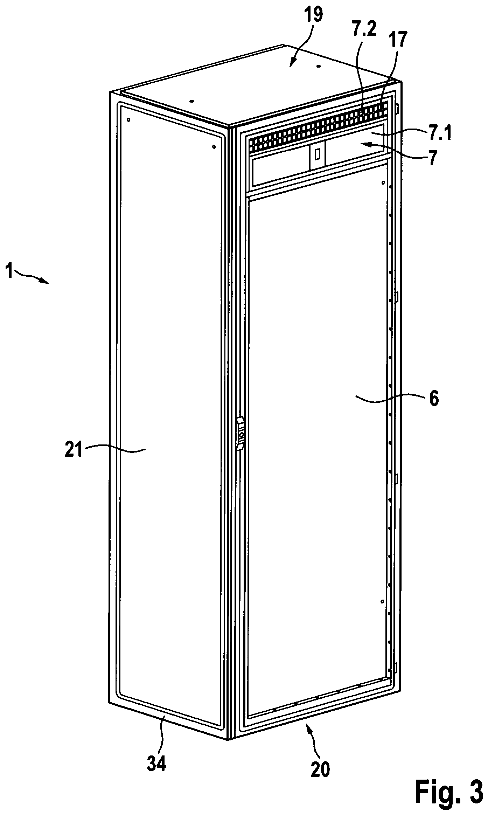

Alle technischen Merkmale des unabhängigen Anspruchs 1 sind obligatorische Merkmale für alle Ausführungsbeispiele der vorliegenden Erfindung. Die Figur 1 zeigt eine Ausführungsform der erfindungsgemäßen Schaltschrankanordnung 1, bei der das Kühlgerät 2 als ein Horizontaleinschubgerät ausgebildet ist, welches im oberen Bereich des Schaltschrankinnenraums 23 unmittelbar unterhalb der Dachseite 19 des Schaltschranks 1 angeordnet ist und sich im Wesentlichen über die gesamte Breite des Schaltschrankinnenraums 23 erstreckt. Das Kühlgerät 2 ist in der ausgezogenen Stellung gezeigt. Im Vergleich dazu zeigt die . Ansicht nach Figur 3 das Kühlgerät 2 in der eingeschobenen Position. Eine Linearverstelleinheit 3 ist vorgesehen, um das Kühlgerät 2 zwischen den beiden in den Figuren 1 und 3 gezeigten Stellungen hin und her zu verstellen.

An einer Vorderseite 22 weist das Kühlgerät einen Luftauslass 8 und einen Lufteinlass 9 auf, über welche der Außenkreis des Kühlgeräts 2 mit der Umgebung des Schaltschrankgehäuses 1 fluidisch in Verbindung steht. In der Darstellung nach Figur 1 nicht erkennbar sind der an der Unterseite des Kühlgeräts, d. h. an der dem Schaltschrankinnenraum 23 zugewandten Seite des Kühlgerätegehäuses 10, angeordnete Kühlluftauslass und der Warmlufteinlass, über die der Innenkreis des Kühlgeräts 2 mit der Luft im Schaltschrankinnenraum 23 fluidisch in Verbindung steht.

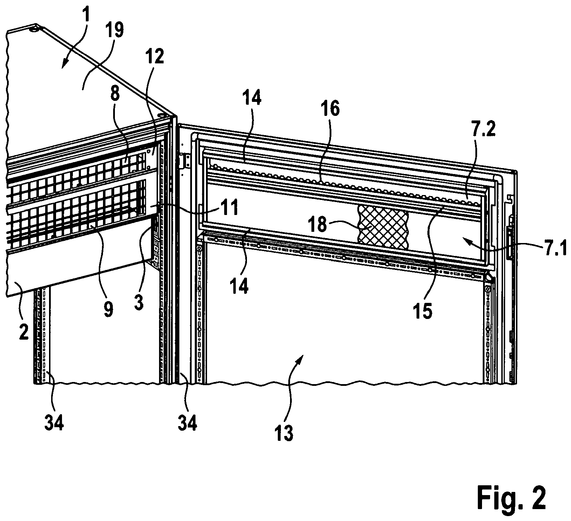

Das Schaltschrankgehäuse 1 weist ein Türelement 6 auf, das an einem Vertikalprofil 34 anscharniert ist. In dem oberen Bereich des Türelements 6 ist eine Luftdurchlassöffnung 7 ausgebildet, welche über einen Trennsteg 15 in eine Lufteintrittsöffnung 7.1 und eine Luftaustrittsöffnung 7.2 unterteilt ist. Wie in der Zusammenschau der Figuren 1 und 2 zu erkennen ist, mündet in der in Figur 2 dargestellten Schließposition des Türelements 6 die Lufteintrittsöffnung 7.1 in den Lufteinlass 9 des Kühlgeräts 2 und die Luftaustrittsöffnung 7.2 in den Luftauslass 8 des Kühlgeräts 2. Der Luftauslass 8 ist an einer Luftauslassseite 12 und der Lufteinlass 9 an einer Lufteinlassseite 11 des Kühlgeräts 2 ausgebildet, wobei die Lufteinlassseite 11 und die Luftauslassseite 12 in der in Figur 3 dargestellten Schließposition des Türelements 6 parallel zu der Türinnenseite 13 des Türelements 6 angeordnet sind.

An der Türinnenseite 13 ist ein die Luftdurchlassöffnung 7 umgebendes Dichtelement 14 ausgebildet, welches in der in Figur 2 dargestellten Längsposition des Türelements 6 an der Lufteinlassseite 11 und der Luftauslassseite 12 dichtend zur Anlage kommt. Das Dichtelement 14 kann beispielsweise eine umlaufend geschlossene Dichtlippe sein.

Um einen Luftkurzschluss zwischen der Lufteintrittsöffnung 7.1 und der Luftaustrittsöffnung 7.2 zu verhindern, sind die beiden über einen Trennsteg 15 fluidisch voneinander abgetrennt. Des Weiteren ist an der Türinnenseite 13 eine Schottung 16 in Form einer Bürstenleiste angeordnet, deren Borsten sich senkrecht zu der Türinnenseite 13 erstrecken und somit in der Schließposition gemäß Figur 3 einen Luftkurzschluss zwischen dem Luftauslass 8 und dem Lufteinlass 9 bzw. zwischen der Lufteintrittsöffnung 7.1 und der Luftaustrittsöffnung 7.2 verhindern. Die Lufteintrittsöffnung 7.1 ist von der Türinnenseite 13 über einen Luftfilter 18 in Form einer luftdurchlässigen Filtermatte verdeckt.

In Figur 3 ist zu erkennen, dass an der Luftaustrittsöffnung 7.2 eine Luftleitgeometrie 17 ausgebildet ist, über die die aus der Luftaustrittsöffnung 7.2 austretende Luft von der Lufteintrittsöffnung 7.1 weggeleitet ist.

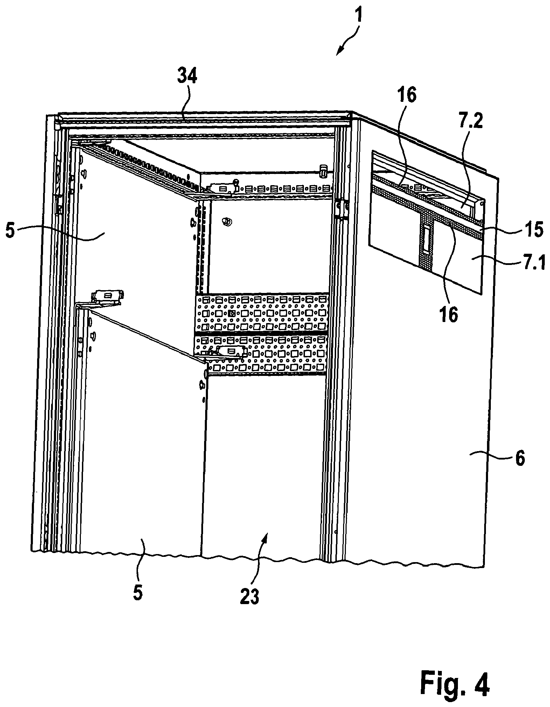

Figur 4 zeigt, dass sich in dem Schaltschrankinnenraum 23 trotz des im oberen Bereich eingebauten Kühlgeräts (nicht dargestellt) eine Montageplatte 5 im Wesentlichen über die gesamte Höhe des Schaltschrankinnenraums 23 erstrecken kann. Eine weitere Montageplatte 5 ist im unteren Bereich des Schaltschrankinnenraums 23 der zuvor genannten Montageplatte 5 vorgelagert.

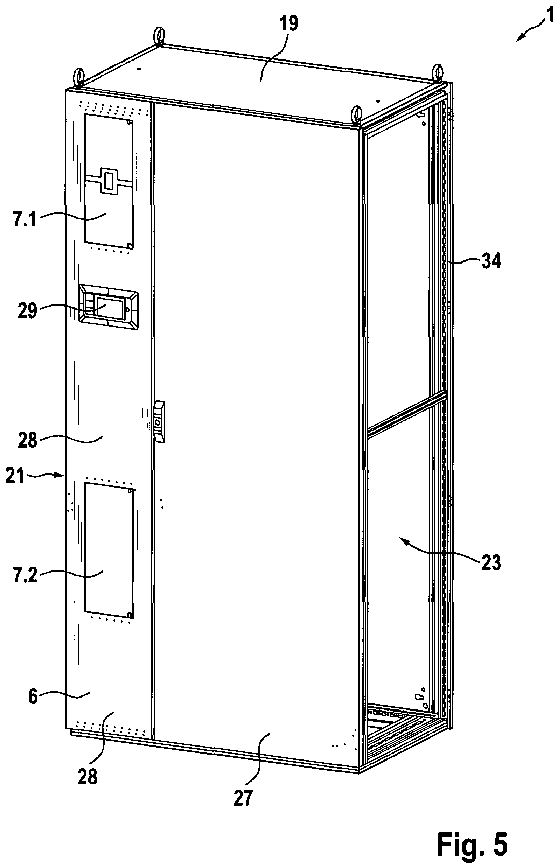

Die Figur 5 zeigt eine weitere Ausführungsform der Erfindung, bei der das Kühlgerät (nicht dargestellt) als ein Vertikaleinschubgerät ausgebildet ist. Das Schaltschrankgehäuse 1 weist ein erstes Türelement 6 auf, über welches das Kühlgerät 2 zugänglich ist, und ein zweites Türelement 27, über welches der Schaltschrankinnenraum 23 zugänglich ist. Auch dieses Schaltschrankgehäuse weist ein Rahmengestell 34 auf, wobei das Kühlgerät (nicht dargestellt) gerade in einem linken Bereich angrenzend an eine Seitenwand 21 des Schaltschrankgehäuses 1 angeordnet ist. Demgemäß begrenzt die vertikale Seitenwand des Kühlgeräts (nicht dargestellt), welche der Seitenwand 21 des Schaltschrankgehäuses abgewandt ist, den Schaltschrankinnenraum 23.

An der Außenseite 28 weist das Türelement 6 im oberen Bereich die Lufteintrittsöffnung 7.1 und in einem unteren Bereich die Luftaustrittsöffnung 7.2 auf. In einem dazwischen liegenden Bereich ist auf der Vorderseite 28 des Türelements 6 ein Gerätedisplay 29 für die Bedienung des Kühlgeräts angeordnet.

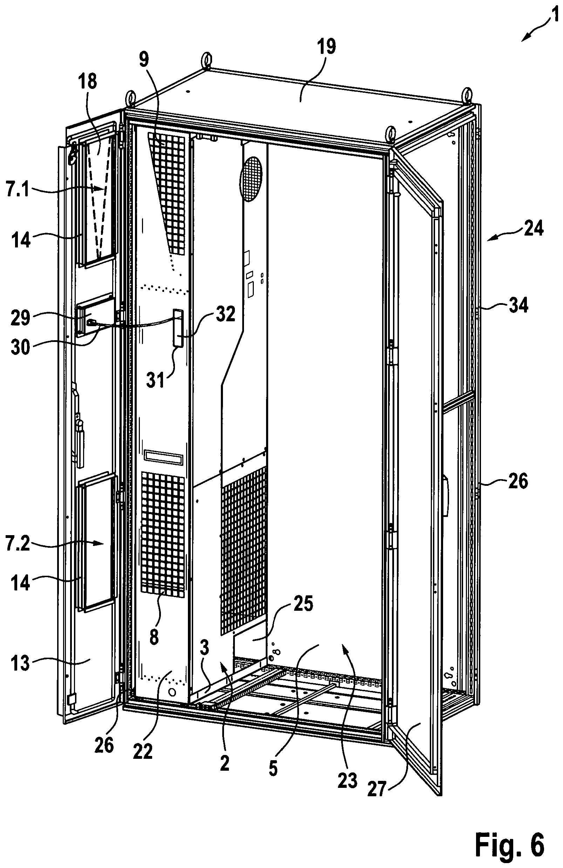

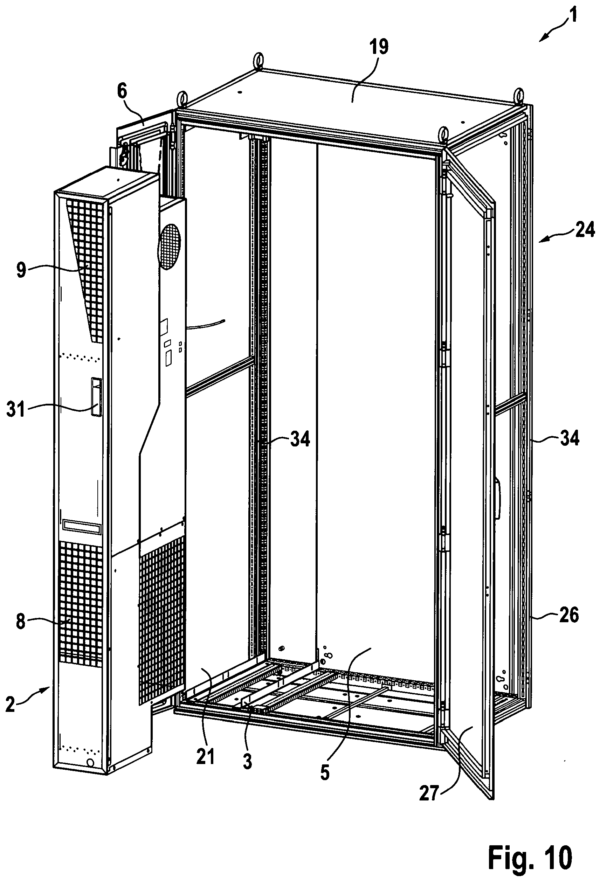

Die Figur 6 zeigt die Schaltschrankanordnung nach Figur 5, wobei die beiden Türelemente 6, 27 geöffnet sind und somit das Kühlgerät 2 und der Schaltschrankinnenraum 23 zugänglich werden. Das Kühlgerät 2 ist über eine Linearverstelleinheit 3 in das Schaltschrankgehäuse 1 eingeschoben. Wie in Figur 10 zu erkennen ist, ist die Linearverstelleinheit 3 im Wesentlichen aus zwei gegenüber stehenden, parallelen L-Profilen gebildet, auf denen das Vertikalkühlgerät 2 in das Schaltschrankgehäuse 1 eingeschoben werden kann.

Das Kühlgerät 2 weist wiederum den Öffnungen 7.1, 7.2 in dem Türelement 6 entsprechend einen Luftauslass 8 und einen Lufteinlass 9 auf. An der Türinnenseite 13 sind Dichtelemente 14 vorgesehen, welche die Öffnungen 7.1, 7.2 umgeben, so dass sie in der Schließposition des Türelements 6 den Luftauslass 8 bzw. den Lufteinlass 9 umschließend dichtend an der dem Türelement 6 zugewandten Vorderseite des Kühlgeräts 2 zur Anlage kommen.

Es ist weiterhin zu erkennen, dass an der Türinnenseite 13 das Displays 29 durch das Türelement 6 hindurchragt und einen Kabelanschluss aufweist, von dem ausgehend sich ein Anschlusskabel 30 von dem Gerätedisplay 29 zu einer Kabelbox 31 in der Vorderseite 22 des Kühlgeräts 2 erstreckt. Über die Kabelbox 31 ist das Anschlusskabel 30 an eine Steuerelektronik im Innern des Kühlgeräts 2 weitergeleitet.

Im rückwärtigen Bereich weist das Kühlgerät 2 in der in Figur 6 dargestellten eingeschobenen Position einen Sammelschienentransferraum 25 auf, so dass in der Anreihsituation, bei der mehrere des in Figur 6 dargestellten Schaltschrankgehäuses 1 und/oder weitere Schaltschränke eine Schaltschrankeihe bilden, Sammelschienen durch die Schaltschrankreihe geführt, werden können, ohne dass dies durch das Kühlgerät 2 behindert würde.

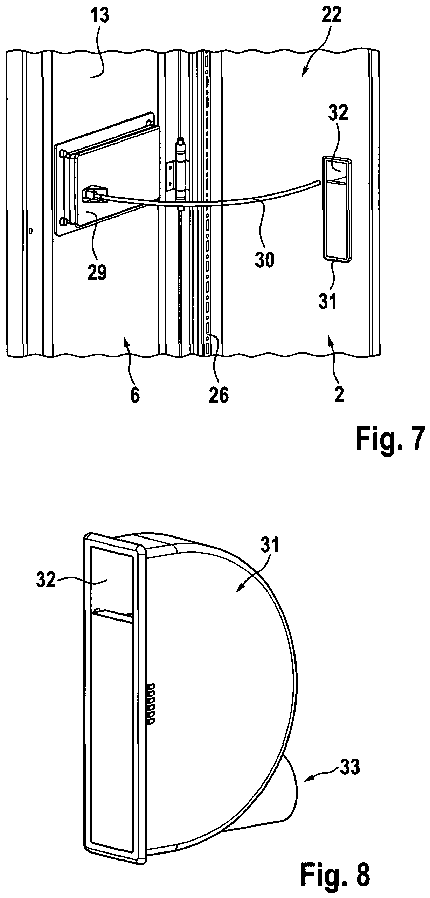

Der Anschluss des Gerätedisplays ist in Figur 7 noch einmal im Detail dargestellt. Das Gerätedisplay 29 ragt türinnenseitig durch das Türelement 6 hindurch und ist über ein Anschlusskabel 30 mit einer Kabelbox 31 verbunden. Die Kabelbox 31 ist darauf ausgelegt, das Kabel in der Schließstellung des Türelements 6 aufzunehmen und in der in Figur 7 dargestellten offenen Stellposition des Türelements 6 freizugeben. Dazu kann in der Kabelbox 31 eine vorgespannte Kabeltrommel aufgenommen sein.

Die Kabelbox 31 ist in Figur 8 gezeigt. Sie weist frontseitig einen Kabeleintritt 32 und rückseitig einen Kabelaustritt 33 auf, über den das Anschlusskabel 30 (siehe Figur 7) aus der Kabelbox 31 austreten kann, um mit einer Steuerelektronik des Kühlgeräts verbunden zu werden.

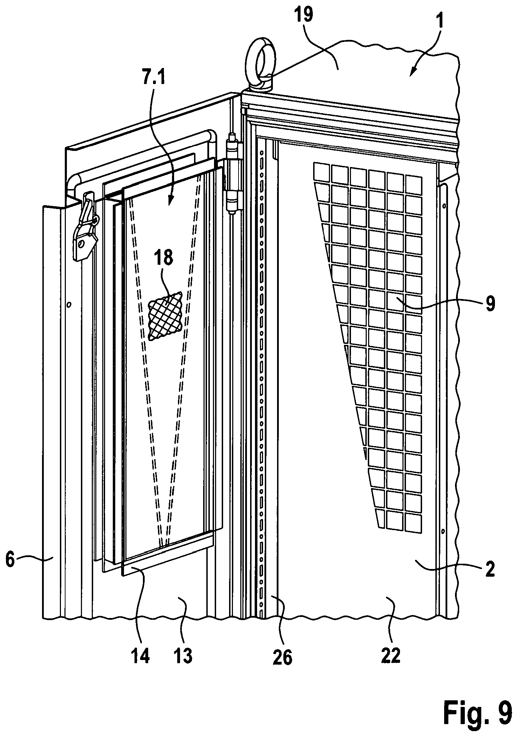

Die Darstellung gemäß Figur 9 zeigt den oberen Bereich der Ausführungsform nach Figur 6. An der Türinnenseite 13 des Türelements 6 ist ein die Lufteintrittsöffnung 7.1 umgebendes Dichtelement 14 angeordnet. Weiterhin ist der Lufteintrittsöffnung 7.1 in Fluidströmungsrichtung durch das Türelement 6 nachgelagert an der Türinnenseite 13 ein Luftfilter 18 in Form einer Filtermatte angeordnet, weiche von dem Dichtelement 14 umgeben wird. Es ist zu erkennen, dass das Dichtelement 14 außen liegende Dichtflansche aufweist, mit denen es in der Schließposition des Türelements 6 an der Vorderseite 22 des Kühlgeräts 2 dichtend zur Anlage kommt und dabei gerade den Lufteinlass des Kühlgeräts 2 umgibt.

In Figur 10 ist das Kühlgerät 2 aus der in den Figuren 5 bis 9 gezeigten Ausführungsform des Schaltschrankgehäuses 1 vollständig entnommen. Dadurch wird die bodenseitig an dem Schaltschrankgehäuse 1 ausgebildete Linearverstelleinheit 3 in Form von zwei gegenüber stehenden L-Profilen erkennbar. Die L-Profile weisen Befestigungsaufhahmen auf und das Kühlgerät bodenseitig entsprechende Gewindeaufnahmen, so dass in einer definierten Anordnung zwischen den L-Profilen und dem Kühlgerät 2 die L-Profile mit dem Kühlgerät 2 verschraubt werden können.

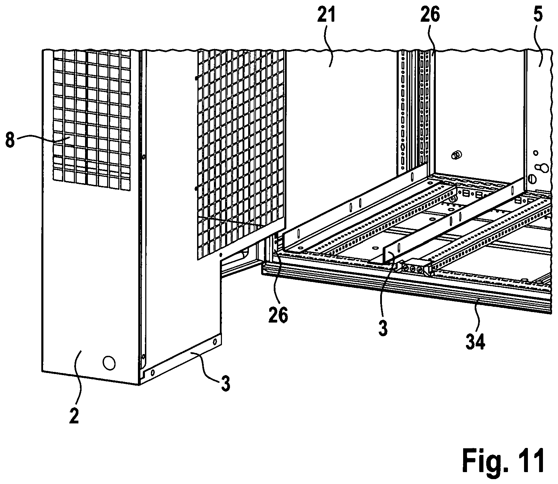

Die Zusammenschau der Figuren 10 und 11 lässt weiterhin erkennen, dass die L-Profile gerade bis an zwei eine Schaltschrankseite begrenzende Vertikalprofile 26 heranreichen, so dass das Kühlgerät 2 platzsparend in dem Schaltschrankgehäuse 1 unmittelbar angrenzend an die in der Darstellung nach Figur 10 linke Seitenwand 21 des Schaltschrankgehäuses 1 aufgenommen werden kann und somit ein möglichst großer Schaltschrankinnenraum 23 für die Aufnahme elektronischer Komponenten verbleibt.

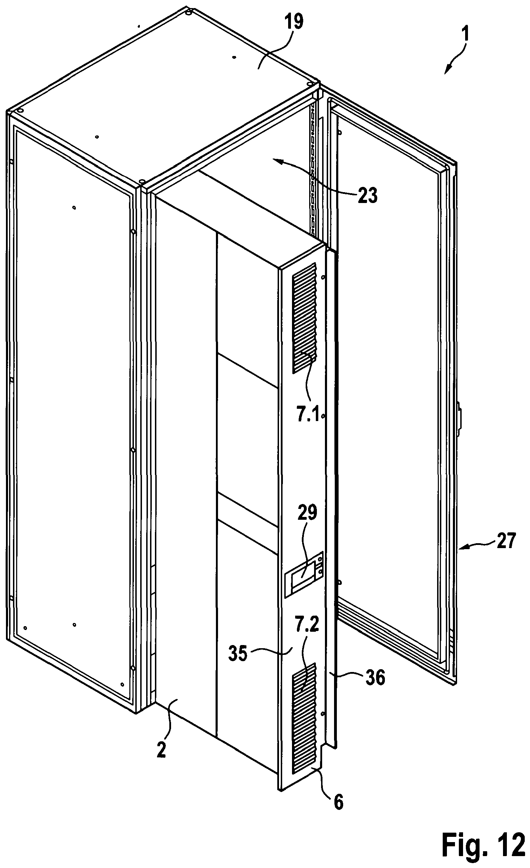

Die Figur 12 zeigt eine Schaltschrankanordnung, die sich darin von der in Figur 6 gezeigten unterscheidet, dass das Türelement 6 statt einer an dem Schaltschrankgehäuses 1 anscharnierten Tür, eine an einer vertikalen, in der Einschubposition der Türseite 4 des Schaltschrankgehäuses 1 zugewandten Gehäuseseite des Kühlgeräts 2 montierte Türpaneele 35 ist, die senkrecht zu der Türseite 4 verstellt werden kann. Die Türpaneele 35 ist fest mit der Gehäuseseite des Kühlgeräts 2 verbunden und weist an ihrer von dem Kühlgerät 2 abgewandten Außenseite einen Griff 36 auf, sodass das Kühlgerät 2 mit der Türpaneele 35 zwischen der Einschubposition und der Auszugposition verstellbar ist. Das weitere Türelement 27 verbleibt, um den Schaltschrankinnenraum 23 wahlweise verschließen zu können. Das das Kühlgerät 2 in der gezeigten Auszugposition nicht vollständig aus dem Gehäuse 1 entnommen ist, bliebt auch in dieser Stellposition bei geschlossenem weiteren Türelement 27 verschlossen.

Die Erfindung ist im unabhängigen Anspruch 1 offenbart. Weitere Ausführungsbeispiele sind in den abhängigen Ansprüchen offenbart.

**Bezugszeichenliste**

| | | | |
|---|---|---|---|
| 1 | Schaltschrankgehäuse | 26 | Vertikalprofil |
| 2 | Kühlgerät | 27 | weiteres Türelement |
| 3 | Linearverstelleinheit | 28 | Außenseite |
| 4 | Türseite | 29 | Gerätedisplay |
| 5 | Montageplatte | 30 | Anschlusskabel |
| 6 | Türelement | 31 | Kabelbox |
| 7 | Luftdurchlassöffnung | 32 | Kabeleintritt |
| 7.1 | Lufteintrittsöffnung | 33 | Kabelaustritt |
| 7.2 | Luftaustrittsöffnung | 34 | Rahmengestell |
| 8 | Luftauslass | 35 | Türpaneele |
| 9 | Lufteinlass | 36 | Griff |
| 10 | Kühlgerätgehäuse | | |
| 11 | Lufteinlassseite | | |
| 12 | Luftauslassseite | | |
| 13 | Türinnenseite | | |
| 14 | Dichtelement | | |
| 15 | Trennsteg | | |
| 16 | Schottung | | |
| 17 | Luftleitgeometrie | | |
| 18 | Luftfilter | | |
| 19 | Dachseite | | |
| 20 | Bodenseite | | |
| 21 | Seitenwand | | |
| 22 | Vorderseite | | |
| 23 | Schaltschrankinnenraum | | |
| 24 | Rückwand | | |
| 25 | Sammelschienentransferraum | | |

## Patentansprüche

1. Schaltschrankanordnung mit einem in einem Schaltschrankgehäuse (1) aufgenommenen Kühlgerät (2), wobei das Kühlgerät (2) über eine Linearverstelleinheit (3), insbesondere ein Schienensystem, an dem Schaltschrankgehäuse (1) verschieblich gehalten und zwischen einer Auszugposition und einer Einschubposition verstellt werden kann, wobei das Kühlgerät (2) in der Einschubposition vollständig in dem Schaltschrankgehäuse (1) aufgenommen und in der Auszugposition zumindest anteilig über eine Türseite (4) des Schaltschrankgehäuses (1) aus dem Schaltschrankgehäuse (1) herausragt, wobei ein die Türseite (4) des Schaltschrankgehäuses (1) in seiner Schließstellung verschließendes Türelement (6) mindestens eine Luftdurchlassöffnung (7) aufweist, die zumindest bei sich in der Einschubposition befindendem Kühlgerät (2) in der Schließstellung des Türelements (6) in einen Luftauslass (8) und einen Lufteinlass (9) des Kühlgeräts (2) mündet, wobei das Kühlgerät (2) ein Kühlgerätgehäuse (10) mit einer Lufteinlassseite (11) und einer Luftauslassseite (12) aufweist, die zumindest in der Schließstellung des Türelements (6) dem Türelement (6) zugewandt und vorzugsweise parallel zu diesem angeordnet sind, wobei in der Schließstellung sowohl der Luftauslass (8) als auch der Lufteinlass (9) des Kühlgeräts (2) in die Luftdurchlassöffnung (7) mündet, und wobei die Luftdurchlassöffnung (7) zweiteilig ausgebildet ist, mit einer Lufteintrittsöffnung (7.1), die in den Lufteinlass (9) des Kühlgeräts (2) mündet, und einer von der Lufteintrittsöffnung (7.1) fluidisch abgetrennten Luftaustrittsöffnung (7.2), die in den Luftauslass (8) des Kühlgeräts (2) mündet.

2. Schaltschrankanordnung nach Anspruch 1, bei der das Türelement (6) an seiner dem Kühlgerät (2) in der Schließstellung zugewandten Türinnenseite (13) ein die Luftdurchlassöffnung (7) umlaufendes Dichtelement (14), insbesondere einen Dichtrahmen aufweist.

3. Schaltschrankanordnung nach Anspruch 2, bei der die Lufteintrittsöffnung (7.1) und die Luftaustrittsöffnung (7.2) über einen die Luftdurchlassöffnung (7) unterteilenden Trennsteg (15) fluidisch voneinander abgetrennt sind, wobei der Trennsteg (15) an der dem Kühlgerät (2) in der Schließstellung des Türelements (6) zugewandten Türinnenseite (13) eine vorstehende Schottung (16), insbesondere eine Bürstenleiste, aufweist, so dass ein Luftkurzschluss zwischen Lufteinlass (9) und Luftauslass (8) unterbunden ist.

4. Schaltschrankanordnung nach Anspruch 1, bei der zumindest die Luftaustrittsöffnung (7.2) eine Luftleitgeometrie (17), insbesondere Lamellen, aufweist, die dazu eingerichtet ist, über die Luftaustrittsöffnung (7.2) aus dem Schaltschrankgehäuse (1) austretende Luft in eine von der Lufteintrittsöffnung (7.1) abgewandte Richtung zu leiten.

5. Schaltschrankanordnung nach einem der vorangegangenen Ansprüche, bei der die Luftdurchlassöffnung (7) eine Lufteintrittsöffnung (7.1) aufweist, die in Luftströmungsrichtung durch die Lufteintrittsöffnung (7.1) nachgelagert an einer dem Kühlgerät (2) in der Schließstellung des Türelements (6) zugewandten Türinnenseite (13) einen Luftfilter (18), insbesondere eine Filtermatte, aufweist.

6. Schaltschrankanordnung nach einem der vorangegangenen Ansprüche, bei der das Kühlgerät (2) ein Horizontaleinschubgerät, welches in einer Einschubebene parallel zu einer Dachseite (19) und/oder einer Bodenseite (20) des Schaltschrankgehäuses (1) verstellbar ist, oder ein Vertikaleinschubgerät ist, welches in einer Einschubebene parallel zu einer Seitenwand (21) des Schaltschrankgehäuses (1) verstellbar ist.

7. Schaltschrankanordnung nach Anspruch 6, bei der sich das Kühlgerät (2),
a) wenn es ein Horizontaleinschubgerät ist, an seiner dem Türelement (6) zugewandten Vorderseite (22) über das gesamte lichte horizontale Maß des Schaltschrankinnenraums (23) erstreckt, und
b) wenn es ein Vertikaleinschubgerät ist, an seiner dem Türelement (6) zugewandten Vorderseite (22) über das gesamte lichte vertikale Einbaumaß des Schaltschrankinnenraums (23) erstreckt,
wobei das Kühlgerät (2) jeweils an seiner einer Rückwand (24) des Schaltschrankgehäuses (1) zugewandten Rückseite einen Sammelschienentransferraum (25) aufweist, der als ein horizontaler Durchlass durch das Kühlgerät (2) ausbildet ist.

8. Schaltschrankanordnung nach einem der vorangegangenen Ansprüche, bei der das Kühlgerät (2) ein Vertikaleinschubgerät ist und angrenzend an zwei seitliche Vertikalprofile (26) eines Rahmengestells des Schaltschrankgehäuses (1) angeordnet ist, so dass ein Schaltschrankinnenraum (23) für die Aufnahme von elektronischen Komponenten von einer von diesen Vertikalprofilen (26) abgewandten Seitenwand des Kühlgeräts (2) begrenzt ist.

9. Schaltschrankanordnung nach Anspruch 8, bei der das Schaltschrankgehäuse (1) an der Türseite eine doppelflügelige Türanordnung aufweist, mit einem ersten Türelement (6), das die Luftdurchlassöffnung (7) aufweist, und mit einem zweiten Türelement (27), das den Schaltschrankinnenraum (23) wahlweise verschließt oder freigibt, so dass das Kühlgerät (2) bei geöffnetem ersten Türelement (6) und bei geschlossenem zweiten Türelement (27) zwischen der Einschubposition und der Auszugposition verstellt werden kann.

10. Schaltschrankanordnung nach einem der vorangegangenen Ansprüche, bei der an einer Außenseite (28) des Türelementes (6) ein Gerätedisplay (29) des Kühlgeräts (2) angeordnet ist, wobei ein Anschlusskabel (30) des Gerätedisplays (29) durch das Türelement (6) hindurchgeführt ist und an einer dem Kühlgerät (2) in der Schließstellung des Türelementes (6) zugewandten Türinnenseite (13) aus dem Türelement (6) heraustritt, wobei das Kühlgerät (2) an seiner dem Türelement (6) zugewandten Vorderseite (22) eine Kabelbox (31) zur Aufnahme des Anschlusskabels (30) aufweist.

11. Schaltschrankanordnung nach Anspruch 10, bei der die Kabelbox (31) einen Kabeleintritt (32) aufweist, über den das an der Türinnenseite (13) des Türelements (6) austretende Anschlusskabel (30) in das Kühlgerät (2) eintritt, wobei das Anschlusskabel (30) in Richtung des Kabeleintritts (32) vorgespannt ist.

12. Schaltschrankanordnung nach einem der vorangegangenen Ansprüche, bei der das Türelement (6) entweder eine an dem Schaltschrankgehäuse (1) über Scharniere schwenkbar befestigte Schaltschranktür ist oder eine an einer vertikalen, in der Einschubposition der Türseite (4) des Schaltschrankgehäuses (1) zugewandten Gehäuseseite des Kühlgeräts (2) montierte Türpaneele (35) ist, die senkrecht zu der Türseite (4) verstellbar ist.

13. Schaltschrankanordnung nach Anspruch 12, bei der die Türpaneele (35) fest mit der Gehäuseseite des Kühlgeräts (2) verbunden ist und an ihrer von dem Kühlgerät (2) abgewandten Außenseite einen Griff aufweist, sodass das Kühlgerät (2) mit der Türpaneele (35) zwischen der Einschubposition und der Auszugposition verstellbar ist.

## Claims

1. A switch cabinet arrangement with a cooling unit (2) accommodated in a switch cabinet housing (1), wherein the cooling unit (2) can be held displaceably on the switch cabinet housing (1) by means of a linear adjustment unit (3), in particular a rail system, and can be adjusted between a pull-out position and a push-in position, wherein the cooling unit (2) is completely accommodated in the switch cabinet housing (1) in the slide-in position and projects out of the switch cabinet housing (1) at least partially via a door side (4) of the switch cabinet housing (1) in the slide-out position, wherein a door element (6) closing the door side (4) of the switch cabinet housing (1) in its closed position has at least one air passage opening (7), **characterized in that** the air passage opening (7) is provided in the switch cabinet housing (1) at least when the door element (6) is in its closed position, which, at least when the cooling unit (2) is in the slide-in position, in the closed position of the door element (6) opens into an air outlet (8) and an air inlet (9) of the cooling unit (2), the cooling unit (2) having a cooling unit housing (10) with an air inlet side (11) and an air outlet side (12) which, at least in the closed position of the door element (6), face the door element (6) and are preferably arranged parallel thereto, wherein, in the closed position, both the air outlet (8) and the air inlet (9) of the cooling unit (2) open into the air passage opening (7), and wherein the air passage opening (7) is designed in two parts, with an air inlet opening (7.1), which opens into the air inlet (9) of the cooling unit (2), and an air outlet opening (7.2), which is fluidically separated from the air inlet opening (7.1) and opens into the air outlet (8) of the cooling unit (2).

2. The switch cabinet arrangement according to claim 1, in which the door element (6) has, on its door inner side (13) facing the cooling unit (2) in the closed position, a sealing element (14), in particular a sealing frame, which surrounds the air passage opening (7).

3. The switch cabinet arrangement according to claim 2, in which the air inlet opening (7.1) and the air outlet opening (7.2) are fluidically separated from one another by means of a separating web (15) which subdivides the air passage opening (7), the separating web (15) having a projecting partition (16), in particular a brush strip, on the door inner side (13) facing the cooling unit (2) in the closed position of the door element (6), so that an air short-circuit between the air inlet (9) and the air outlet (8) is prevented.

4. The switch cabinet arrangement according to claim 1, in which at least the air outlet opening (7.2) has an air guide geometry (17), in particular lamellae, which is adapted to guide air emerging from the switch cabinet housing (1) via the air outlet opening (7.2) in a direction facing away from the air inlet opening (7.1).

5. The switch cabinet arrangement according to one of the preceding claims, in which the air passage opening (7) has an air inlet opening (7.1) which has an air filter (18), in particular a filter mat, downstream in the air flow direction through the air inlet opening (7.1) on a door inner side (13) facing the cooling unit (2) in the closed position of the door element (6).

6. The switch cabinet arrangement according to any one of the preceding claims, wherein the cooling unit (2) is a horizontal insertion device which is adjustable in an insertion plane parallel to a roof side (19) and/or a bottom side (20) of the switch cabinet housing (1), or a vertical insertion device which is adjustable in an insertion plane parallel to a side wall (21) of the switch cabinet housing (1).

7. Control cabinet arrangement according to claim 6, wherein the cooling unit (2),
a) if it is a horizontal insertion device, extends at its front side (22) facing the door element (6) over the entire clear horizontal dimension of the switch cabinet interior (23), and
b) if it is a vertical insertion device, extends at its front side (22) facing the door element (6) over the entire clear vertical installation dimension of the switch cabinet interior (23),
the cooling unit (2) having, in each case on its rear side facing a rear wall (24) of the switch cabinet housing (1), a busbar transfer space (25) which is formed as a horizontal passage through the cooling unit (2).

8. The switch cabinet arrangement according to any one of the preceding claims, wherein the cooling unit (2) is a vertical insertion device and is arranged adjacent to two lateral vertical profiles (26) of a frame of the switch cabinet housing (1), so that a switch cabinet interior (23) for accommodating electronic components is limited by a sidewall of the cooling unit (2) facing away from these vertical profiles (26).

9. The switch cabinet arrangement according to claim 8, in which the switch cabinet housing (1) has a double-leaf door arrangement on the door side, with a first door element (6), which has the air passage opening (7), and with a second door element (27), which selectively closes or exposes the switch cabinet interior (23), so that the cooling unit (2) can be adjusted between the slide-in position and the slide-out position when the first door element (6) is open and when the second door element (27) is closed.

10. The switch cabinet arrangement according to one of the preceding claims, in which an device display (29) of the cooling unit (2) is arranged on an outer side (28) of the door element (6), wherein a connecting cable (30) of the device display (29) is passed through the door element (6) and emerges from the door element (6) at a door inner side (13) facing the cooling unit (2) in the closed position of the door element (6), wherein the cooling unit (2) has a cable box (31) at its front side (22) facing the door element (6) for receiving the connecting cable (30).

11. The switch cabinet arrangement according to claim 10, in which the cable box (31) has a cable inlet (32) via which the connecting cable (30) exiting at the door inner side (13) of the door element (6) enters the cooling unit (2), the connecting cable (30) being prestressed in the direction of the cable inlet (32).

12. The switch cabinet arrangement according to any one of the preceding claims, wherein the door element (6) is either a switch cabinet door pivotally attached to the switch cabinet housing (1) via hinges or is a door panel (35) mounted on a vertical housing side of the cooling unit (2) facing the door side (4) of the switch cabinet housing (1) in the insertion position, which door panel (35) is adjustable perpendicular to the door side (4).

13. The switch cabinet arrangement according to claim 12, wherein the door panel (35) is fixedly connected to the housing side of the cooling unit (2) and has a handle on its outer side facing away from the cooling unit (2), so that the cooling unit (2) is adjustable with the door panel (35) between the slide-in position and the slide-out position.

## Revendications

1. Disposition d'armoire de commande avec un appareil de refroidissement (2) logé dans un boîtier d'armoire de commande (1), dans lequel l'appareil de refroidissement (2) est maintenu de manière coulissante sur le boîtier d'armoire de commande (1) par l'intermédiaire d'une unité de déplacement linéaire (3), plus particulièrement d'un système à glissière et peut être déplacé entre une position déployée et une position rétractée, dans lequel l'appareil de refroidissement (2), dans la position rétractée, est logé entièrement dans le boîtier d'armoire de commande (1) et, dans la position déployée, dépasse au moins en partie d'un côté de porte (4) du boîtier d'armoire de commande (1) hors du boîtier d'armoire de commande (1), dans lequel un élément de porte (6), fermant le côté de porte (4) du boîtier d'armoire de commande (1) dans sa position de fermeture, comprenant au moins une ouverture de passage d'air (7) qui, au moins lorsque l'appareil de refroidissement (2) se trouve dans la position rétractée, débouche, dans la position de fermeture de l'élément de porte (6), dans une sortie d'air (8) et une entrée d'air (9) de l'appareil de refroidissement (2), dans lequel l'appareil de refroidissement (2) comprend un boîtier d'appareil de refroidissement (10) avec un côté d'entrée d'air (11) et un côté de sortie d'air (12), qui, au moins dans la position de fermeture de l'élément de porte (6), sont orientés vers l'élément de porte (6) et sont disposés de préférence parallèlement à celui-ci, dans lequel, dans la position de fermeture, la sortie d'air (8) ainsi que l'entrée d'air (9) de l'appareil de refroidissement (2) débouchent dans l'ouverture de passage d'air (7) et dans lequel l'ouverture de passage d'air (7) est conçue en deux parties, avec une ouverture d'entrée d'air (7.1) qui débouche dans l'entrée d'air (9) de l'appareil de refroidissement (2), et une ouverture de sortie d'air (7.2), séparée fluidiquement de l'ouverture d'entrée d'air (7.1), qui débouche dans la sortie d'air (8) de l'appareil de refroidissement (2).

2. Disposition d'armoire de commande selon la revendication 1, dans laquelle l'élément de porte (6) comprend, sur son côté interne de porte (13) orienté vers l'appareil de refroidissement (2) dans la position de fermeture ; un élément d'étanchéité (14), plus particulièrement un cadre d'étanchéité, entourant l'ouverture de passage d'air (7).

3. Disposition d'armoire de commande selon la revendication 2, dans laquelle l'ouverture d'entrée d'air (7.1) et l'ouverture de sortie d'air (7.2) sont séparées fluidiquement l'une de l'autre par une nervure de séparation (15) divisant l'ouverture de passage d'air (7), dans lequel la nervure de séparation (15) comprend, sur le côté interne de porte (13) orienté vers l'appareil de refroidissement (2) dans la position de fermeture de l'élément de porte (6), une cloison en saillie (16), plus particulièrement une bande à brosse, de façon à ce qu'un court-circuit d'air entre l'entrée d'air (9) et la sortie d'air (8) soit empêché.

4. Disposition d'armoire de commande selon la revendication 1, dans laquelle au moins l'ouverture de sortie d'air (7.2) présente une géométrie de guidage d'air (17), plus particulièrement des lamelles, qui est conçue pour guider l'air sortant par l'ouverture de sortie d'air (7.2) hors du boîtier d'armoire de commande (1) dans une direction opposée à l'ouverture d'entrée d'air (7.1).

5. Disposition d'armoire de commande selon l'une des revendications précédentes, dans laquelle l'ouverture de passage d'air (7) comprend une ouverture d'entrée d'air (7.1) qui comprend en aval, dans la direction d'écoulement de l'air à travers l'ouverture d'entrée d'air (7.1), sur un côté interne de porte (13), orienté vers l'appareil de refroidissement (2) dans la position de fermeture de l'élément de porte (6), un filtre à air (18), plus particulièrement un tapis filtrant.

6. Disposition d'armoire de commande selon l'une des revendications précédentes, dans laquelle l'appareil de refroidissement (2) est un appareil à rack horizontal qui peut être déplacé dans un plan de rack parallèlement à un côté de toit (19) et/ou un côté de plancher (20) du boîtier d'armoire de commande (1), ou un appareil à rack vertical, qui peut être déplacé dans un plan de rack parallèle à une paroi latérale (21) du boîtier d'armoire de commande (1).

7. Disposition d'armoire de commande selon la revendication 6, dans laquelle l'appareil de refroidissement (2)
a) lorsqu'il est un appareil à rack horizontal, s'étend, sur un côté avant (22) orienté vers l'élément de porte (6), sur toute la dimension horizontale interne de l'espace interne de l'armoire de commande (23) et
b) lorsqu'il est un appareil à rack vertical, s'étend, sur un côté avant (22) orienté vers l'élément de porte (6), sur toute la dimension verticale interne d'encastrement de l'espace interne de l'armoire de commande (23),
dans laquelle l'appareil de refroidissement (2) comprend, au niveau d'un côté arrière orienté vers une paroi arrière (24) du boîtier d'armoire de commande (1), un espace de transfert de rail collecteur (25) qui est conçu comme un passage horizontal à travers l'appareil de refroidissement (2).

8. Disposition d'armoire de commande selon l'une des revendications précédentes, dans laquelle l'appareil de refroidissement (2) est un appareil à rack vertical et est disposé de manière adjacente à deux profilés verticaux latéraux (26) d'un châssis du boîtier d'armoire de commande (1), de façon à ce qu'un espace interne de l'armoire de commande (23) pour le logement de composants électroniques soit délimité par une paroi latérale de l'appareil de refroidissement (2) opposée à ces profilés verticaux (26).

9. Disposition d'armoire de commande selon la revendication 8, dans laquelle le boîtier d'armoire de commande (1) comprend, sur le côté de la porte, une disposition de porte à double battant, avec un premier élément de porte (6), qui comprend l'ouverture de passage d'air (7), et avec un deuxième élément de porte (27), qui ferme ou libère l'espace interne de l'armoire de commande (23), de façon à ce que l'appareil de refroidissement (2), lorsque le premier élément de porte (6) est ouvert et le deuxième élément de porte (27) est fermé, puisse être déplacé entre la position rétractée et la position déployée.

10. Disposition d'armoire de commande selon l'une des revendications précédentes, dans laquelle, sur un côté externe (28) de l'élément de porte (6), est disposé un écran d'appareil (29) de l'appareil de refroidissement (2), dans lequel un câble de raccordement (30) de l'écran d'appareil (29) est guidé à travers l'élément de porte (6) et sort de l'élément de porte (6) au niveau d'un côté interne de porte (13) orienté vers l'appareil de refroidissement (2) dans la position de fermeture de l'élément de porte (6), dans lequel l'appareil de refroidissement (2) comprend, sur son côté avant (22) orienté vers l'élément de porte (6), une boîte à câble (31) pour le logement du câble de raccordement (30).

11. Disposition d'armoire de commande selon la revendication 10, dans laquelle la boîte à câble (31) comprend une entrée de câble (32), par l'intermédiaire de laquelle le câble de raccordement (30) sortant au niveau du côté interne de porte (13) de l'élément de porte (6) entre dans l'appareil de refroidissement (2), dans lequel le câble de raccordement (30) est précontraint en direction de l'entrée de câble (32).

12. Disposition d'armoire de commande selon l'une des revendications précédentes, dans laquelle l'élément de porte (6) est soit une porte d'armoire de commande fixée de manière pivotante au boîtier d'armoire de commande (1) par l'intermédiaire de charnières, soit un panneau de porte (35) monté sur un côté de boîtier vertical de l'appareil de refroidissement (2), orienté, dans la position rétractée, vers le côté de porte (4) du boîtier d'armoire de commande (1), qui est mobile perpendiculairement par rapport au côté de porte (4).

13. Disposition d'armoire de commande selon la revendication 12, dans laquelle le panneau de porte (35) est relié fermement avec le côté de boîtier de l'appareil de refroidissement (2) et comprend, au niveau de son côté externe opposé à l'appareil de refroidissement (2), une poignée, de façon à ce que l'appareil de refroidissement (2) puisse être déplacé, avec le panneau de porte (35), entre la position rétractée et la position déployée.
